(19) Europäisches Patentamt
European Patent Office
Office européen des brevets

(11) EP 2 818 878 A1

(12) # EUROPEAN PATENT APPLICATION
published in accordance with Art. 153(4) EPC

(43) Date of publication:
**31.12.2014 Bulletin 2015/01**

(21) Application number: **12868269.7**

(22) Date of filing: **09.02.2012**

(51) Int Cl.:
***G01R 22/00*** *(2006.01)*

(86) International application number:
**PCT/JP2012/053022**

(87) International publication number:
**WO 2013/118282 (15.08.2013 Gazette 2013/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Mitsubishi Electric Corporation**
**Tokyo 100-8310 (JP)**

(72) Inventors:
- **TAKADA, Kenichi**
  **Tokyo 100-8310 (JP)**
- **SATO, Naoko**
  **Tokyo 100-8310 (JP)**

(74) Representative: **Hoffmann Eitle**
**Patent- und Rechtsanwälte PartmbB**
**Arabellastraße 30**
**81925 München (DE)**

(54) **ELECTRICITY METER, METHOD FOR DETECTING THEFT OF ELECTRICITY METER, AND POWER SUPPLY SYSTEM**

(57) An electricity meter forms a wireless mesh network with one or more data collecting devices collecting electric energy data. The electricity meter includes a wireless communication unit (a wireless unit 51, a data-relay processing unit 53) that transmits an amount of electricity consumed by a customer directly or via other adjacent electricity meters to a data collecting device selected as a data transmission destination, a wireless communication control unit 57 that determines existence of a movement of the electricity meter itself based on the number of variations in adjacent electricity meters and existence of a variation in a reception level of a signal transmitted from each of the adjacent electricity meters, and relay 62 that stops an operation of a circuit of supplying electric power to a customer when it is determined that "movement exists".

FIG.4

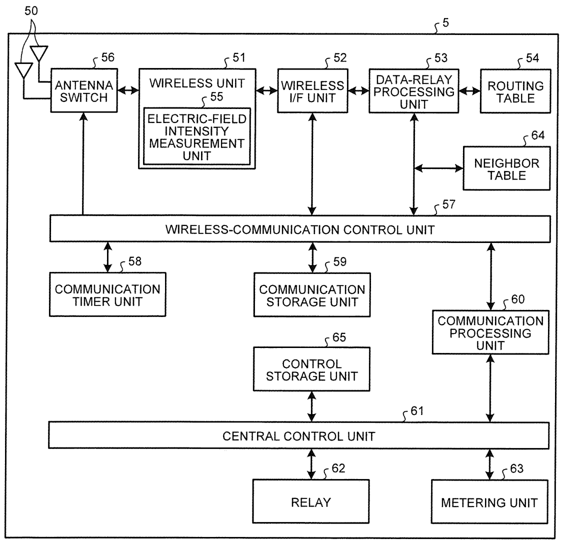


EP 2 818 878 A1

Printed by Jouve, 75001 PARIS (FR)

## Description

Field

The present invention relates to an electricity meter for metering electric energy and the like.

Background

An electricity meter is installed in a house or a factory of a consumer by an electric power company, and meters and measures the amount of electricity such as used electric energy and a current. By illegally implementing wiring in an electricity meter after its installation, theft of electricity that is to tamper the used electric energy to reduce electric-power charges to be charged is sometimes committed. To deal with theft of electricity, a conventional electricity meter detects currents on an upstream side and a downstream side of a wired line connected to the electricity meter and detects theft of electricity by a difference between the upstream current and the downstream current (see, for example, Patent Literature 1).

Citation List

Patent Literature

Patent Literature 1: Japanese Patent Application Laid-open No. 2004-340767

Summary

Technical Problem

A prepayment system is applied in some countries. According to this system, when a consumer (a customer) pays fixed charges to an electric power company, information about the charges (charge information) is registered in an electricity meter and the electricity meter starts electric-power supply. When electric power corresponding to the paid charges is consumed thereafter, the electric-power supply is stopped. In this system, theft of electricity can be committed by stealing the electricity meter in which prepaid charge information is registered from an installation place and installing this electricity meter again in another place. However, the theft of electricity cannot be detected by the above conventional electricity theft detection method and an unused part of the electric power corresponding to the prepaid charges is used (theft of electricity is committed) by a thief.

The present invention has been achieved in view of the above problems, and an object of the present invention is to provide an electricity meter, a theft detection method of an electricity meter, and an electric-power supply system that can prevent theft of electricity even in an electric-power supply system that applies a prepayment system.

Solution to Problem

In order to solve the above problem and in order to attain the above object, in an electricity meter that forms a wireless mesh network with one or more data collecting devices collecting electric energy data, the electricity meter of the present invention, includes: a wireless communication unit that transmits an amount of electricity consumed by a customer directly or via other adjacent electricity meters to a data collecting device selected as a data transmission destination; a movement detection unit that determines existence of a movement of the electricity meter itself based on number of variations in adjacent electricity meters and existence of a variation in a reception level of a signal transmitted from each of the adjacent electricity meters; and an electric-power supply control unit that stops an operation of a circuit of supplying electric power to a customer when it is determined that "movement exists" by the movement detection unit.

Advantageous Effects of Invention

According to the present invention, it is possible to prevent theft of electricity of an unused part of electric power corresponding to prepaid charges by a thief of an electricity meter even in a case where a prepayment system is applied.

Brief Description of Drawings

FIG. 1 is a configuration example of a wireless mesh system according to a first embodiment.
FIG. 2 is a configuration example of a data collecting device.
FIG. 3 is a configuration example of a wireless processing unit included in the data collecting device.
FIG. 4 is a configuration example of an electricity meter.
FIG. 5 is an example of a theft detection procedure of the electricity meter according to the first embodiment.
FIG. 6 is a movement example of the electricity meter according to the first embodiment.
FIG. 7 is an neighbor table corresponding to the movement example in FIG. 6.
FIG. 8 is a movement example of the electricity meter according to the first embodiment.
FIG. 9 is an neighbor table corresponding to the movement example in FIG. 8.
FIG. 10 is a movement example of the electricity meter according to the first embodiment.
FIG. 11 is an neighbor table corresponding to the movement example in FIG. 10.
FIG. 12 is an example of a theft detection procedure of an electricity meter according to a second embodiment.
FIG. 13 is a movement example of the electricity meter according to the second embodiment.
FIG. 14 is a movement example of the electricity meter according to the second embodiment.
FIG. 15 is a movement example of the electricity meter according to the second embodiment.
FIG. 16 is an example of a theft detection procedure of an electricity meter according to a third embodiment.
FIG. 17 is a movement example of the electricity meter according to the third embodiment.

## Description of Embodiments

Exemplary embodiments of an electricity meter, a theft detection method of an electricity meter, and an electric-power supply system according to the present invention will be explained below in detail with reference to the accompanying drawings. The present invention is not limited to the embodiments.

### First embodiment.

An electricity meter according to a first embodiment of the present invention is explained with reference to FIGS. 1 to 11. The electricity meter according to the present embodiment has a wireless communication function, in addition to an original function as an electricity meter, that is, a function of supplying electric power to a customer’s site (a house or a factory) in which the electricity meter is installed and of metering/measuring the amount of consumed electricity. This wireless communication function enables a wireless mesh network to be formed. Information such as the amount of measured electricity is transmitted via the wireless mesh network to a data collecting device. Also in a case of transmitting and receiving various information between the electricity meter and another device having a communication function (the data collecting device or another electricity meter), the transmission and reception is performed via the wireless mesh network.

FIG. 1 is a configuration example of a wireless mesh system according to the first embodiment including a wireless mesh network (hereinafter, "wireless network") formed by the electricity meter according to the present invention.

The wireless mesh system according to the present embodiment constitutes an electric-power supply system. As shown in FIG. 1, the electric-power supply system is constituted by electricity meters 5 each of which meters electric energy and transmits the obtained data in a wireless mode as required, data collecting devices 2 each of which transmits and receives various data to and from the electricity meter 5 by wireless communication, and a management server 1 that is connected via a wide area network 3 provided by a telecommunications carrier to the data collecting device 2. While an example of a case of wired-connecting the management server 1 to the data collecting device 2 is described, wireless connection is possible as long as a desired communication quality can be realized. Each data collecting device 2 has the same function and each electricity meter 5 has the same function. In FIG. 1, each data collecting device 2 and each electricity meter 5 are shown by a device ID being attached thereto. In the following explanations, when the data collecting devices 2 need to be distinguished from each other, this ID is used. Specifically, the data collecting devices are represented as "data collecting device 2AA" and "data collection device 2BB". Similarly, when the electricity meters 5 need to be distinguished from each other, the electricity meters are represented as "electricity meter 5A", "electricity meter 5B", and the like.

An outline of internal configurations and operations of the respective devices constituting the wireless mesh system shown in FIG. 1 is explained first.

Although detailed configurations thereof are not shown in FIG. 1, the management server 1 includes a central control unit that controls functions of the system, a communication control unit for communicating with the data collecting device 2 via the wide area network 3, and a storage device that holds data such as the electric energy obtained from the electricity meter 5 via the data collecting device 2.

FIG. 2 is a configuration example of the data collecting device 2. As shown in FIG. 2, the data collecting device 2 includes a data-collecting-device central control unit 21 that performs data processing with respect to the management server 1 or the electricity meter 5, a wireless processing unit 22 that performs wireless communication control for wireless-network communicating with the electricity meter 5, an optical input/output unit 24 for connecting to the wide area network 3 via an optical cable 4, and a communication processing unit 23.

FIG. 3 is a configuration example of the wireless processing unit 22 included in the data collecting device 2. As shown in FIG. 3, the wireless processing unit 22 includes an antenna switch 36 that switches a plurality of antennas 30, a wireless unit 31 that measures an electric-field intensity level with respect to the electricity meter 5 shown in FIG. 1 in an electric-field intensity measurement unit 35 and performs a wireless modulation/demodulation process for communicating with the electricity meter 5, a wireless I/F (Interface) unit 32, a wireless-network control unit 33 that performs configuration management of the wireless network formed by the electricity meter 5, a routing table 34 that stores therein information about a path to each electricity meter 5 required for transmitting data to the electricity meter 5 based on an address, and a wireless-communication control unit 37 that controls all functions of the wireless processing unit 22, performs a data transmitting/receiving process with respect to the data-collecting-device central control unit 21, and controls the antenna switch 36.

In the data collecting device 2 having the configuration shown in FIGS. 2 and 3, communication (data transmission/reception) with the electricity meter 5 is performed via the antenna 30, the wireless unit 31, and the wireless I/F unit 32 in the wireless processing unit 22.

The wireless-network control unit 33 of the wireless processing unit 22 communicates with other electricity meters 5 forming the wireless network via the antenna 30 and the wireless unit 31 to assign addresses to all electricity meters 5, register and manage the addresses.

When the data collecting device 2 receives request data from the management server 1, the received request data is transferred via the optical input/output unit 24 and the communication processing unit 23 to the data-collecting-device central control unit 21 and after predetermined data processing is performed in the data-collecting-device central control unit 21, and then transferred to the wireless processing unit 22. In the wireless processing unit 22, the transferred request data is received by the wireless-network control unit 33. The wireless-network control unit 33 transmits the request data via the wireless I/F unit 32, the wireless unit 31, the antenna switch 36, and the antenna 30 to the electricity meter 5 specified by the management server 1 according to the path information stored in the routing table 34.

FIG. 4 is a configuration example of the electricity meter 5. As shown in FIG. 4, the electricity meter 5 includes a plurality of antennas 50 used for wireless-communicating with the data collecting device 2 and another electricity meter 5, an antenna switch 56 that switches a used antenna, a wireless unit 51 that measures an electric-field intensity level with respect to other devices forming the wireless network (the data collecting device 2 or another electricity meter 5) in an electric-field intensity measurement unit 55 and performs the wireless modulation/demodulation process for communicating with the other device, a wireless I/F unit 52, a routing table 54 that stores therein information about a path to another device forming the wireless network, a data-relay processing unit 53 that transmits various information including measurement data in the corresponding electricity meter and measurement data received from another device to another device according to the path information, an neighbor table 64 that holds information such as the electric-field intensity level with respect to peripheral data collecting devices 2 or another electricity meter 5 and the number of hops from each of peripheral electricity meters 5 to the data collecting device 2, a wireless-communication control unit 57 that has various functions including a function of processing data directed to the corresponding electricity meter 5 and controls the antenna switch 56 and the wireless I/F unit 52, a communication timer unit 58 for periodically obtaining the various information held in the neighbor table 64, a metering unit 63 that meters the used electric energy by a consumer in an environment where the electricity meter itself (the corresponding electricity meter) is installed and values related to the amount of electricity such as a current, a voltage, and a frequency, a control storage unit 65 that stores therein the values related to the amount of electricity, relay 62 serving as an electric-power supply control unit that opens and closes an electric circuit built in the electricity meter to switch between start and stop of electric-power supply to a customer (a consumer), a central control unit 61 that controls the respective units for realizing the original function as the electricity meter such as the relay 62 and the metering unit 63, and a communication processing unit 60 for realizing communication between the wireless-communication control unit 57 and the central control unit 61. The wireless-communication control unit 57 also performs processing as a movement detection unit. The wireless unit 51 and the data-relay processing unit 53 perform processing as a wireless communication unit.

In the electricity meter 5, the central control unit 61, the relay 62, the metering unit 63, and the control storage unit 65 provide the original function as an electricity meter (a function of supplying electric power to a customer and metering and measuring the amount of consumed electricity). The antenna 50, the antenna switch 56, the wireless unit 51, the wireless I/F unit 52, the data-relay processing unit 53, the routing table 54, the wireless-communication control unit 57, the neighbor table 64, the communication timer unit 58, and a communication storage unit 59 provide the wireless communication function including a function for forming the wireless network and a function for communicating with other devices and a device-theft detection function.

In the electricity meter 5 shown in FIG. 4, communication (data transmission/reception) with the data collecting device 2 or another electricity meter 5 is performed via the antenna 50, the wireless unit 51, and the wireless I/F unit 52.

In the electricity meter 5, when the electricity meter 5 receives data from the management server 1 or another electricity meter 5, the data-relay processing unit 53 determines whether the data is directed to the corresponding electricity meter 5 or another electricity meter 5. When the data is directed to the corresponding electricity meter 5, the received data is transferred to the wireless-communication control unit 57 and the wireless-communication control unit 57 performs predetermined processing. When response data to the received data needs to be transmitted, the response data is transferred from the wireless-communication control unit 57 to the data-relay processing unit 53 and transmitted via the wireless I/F unit 52, the wireless unit 51, and the antenna 50 according to the path information stored in the routing table 54. Meanwhile, when the received data is directed to another electricity meter 5, the data-relay processing unit 53 transmits (transfers) the received data via the wireless I/F unit 52, the wireless unit 51, and the antenna 50 according to the path information. The received data sometimes includes routing information indicating a communication path. In this case, the data-relay processing unit 53 performs relay processing of the received data (transfers the received data) according to the routing information included in the received data.

When the wireless-communication control unit 57 receives various data and information indicating an operating state of the electricity meter via the communication processing unit 60 from the central control unit 61, the wireless-communication control unit 57 stores the various data and the information in the communication storage unit 59. "Information indicating operating state" is information indicating a maintenance mode that the electricity meter 5 performs an operation during maintenance and inspection or a monitoring mode that the electricity meter 5 is installed at a customer's site, meters the electric energy, and should detect theft.

When the communication timer unit 58 starts an operation, the communication timer unit 58 sends a notification to the wireless-communication control unit 57 every time when a certain period of time defined in advance has elapsed. When the wireless-communication control unit 57 receives the notification, the wireless-communication control unit 57 transmits an information data request to other peripheral electricity meters 5. When an information data response is transmitted as a response to the information data request, the electric-field-intensity measurement unit 55 of the wireless unit 51 measures a reception level (the electric-field intensity level) of the information data response. The wireless-communication control unit 57 receives the electric-field intensity level obtained by the measurement of the electric-field intensity measurement unit 55 and the number of hops to the data collecting device 2 included in the received information data response and stores them in the neighbor table 64. The wireless-communication control unit 57 performs theft detection of the corresponding electricity meter 5 based on the information stored in the neighbor table 64.

Next, a theft detection operation by the electricity meter 5 is explained with reference to FIG. 5. FIG. 5 is an example of a theft detection procedure of the electricity meter 5 according to the first embodiment.

When the electricity meter 5 having the configuration shown in FIG. 4 is activated, whether the electricity meter 5 is in the monitoring mode requiring the theft detection operation is confirmed (Step S11). When the electricity meter 5 is not in the monitoring mode (NO at Step S11), the operation of confirming whether the electricity meter 5 is in the monitoring mode is repeated at a predetermined timing. When the electricity meter 5 is in the monitoring mode (YES at Step S11), a threshold of a movement determination computation is set (Step S12).

When setting of the movement determination threshold ends, the electricity meter 5 sets a timer value as a period of performing a movement detection process (Step S13).

When setting of the timer value ends, the electricity meter 5 monitors whether it has become a timer-set time, that is, whether it has become a timing of starting the movement detection process (Step S14). When the timing of starting the movement detection process is detected (YES at Step S14), a data request is transmitted by broadcast (Step S15). The electricity meter 5 and the data collecting device 2 receiving the data request transmit a data response. The electricity meter 5 receiving the data request does not transfer the data request.

The electricity meter 5 that transmits the data request monitors whether the data response has been received (Step S16) and whether a certain period of time has elapsed (Step S18). When the data response is received (YES at Step S16), the electric-field intensity of a received signal (the received data response) is measured (Step S17). At this time, among information included in the received data response, an ID of a device transmitting the data response (another electricity meter 5 or the data collecting device 2) and the number of hops from another electricity meter 5 to the data collecting device 2 are obtained and held together with the measured electric-field intensity. Until a certain period of time elapses, every time when the data response is received, an operation of measuring the electric-field intensity of the received signal and an operation of obtaining the device ID and the number of hops are performed.

When the certain period of time has elapsed since the data request is transmitted (YES at Step S18), the neighbor table 64 is updated (Step S19). That is, a result of the electric-field intensity measurement performed before the certain period of time elapses (the electric-field intensity level, the ID of the device transmitting the data response, and the number of hops) is registered and held in the neighbor table 64. While an operation of updating the neighbor table 64 after the certain period of time has elapsed is explained, the neighbor table 64 can be updated every time when the data response is received. In this case, information before update is also held as history information for a certain time period. The electric-field intensity level is not the electric-field intensity measurement result itself but information converted so that measurement results included in a certain range are integrated and indicated by the same numeral value.

Next, the movement determination computation of the corresponding electricity meter 5 is performed based on the information registered in the neighbor table 64 (Step S20). The movement determination computation can be performed by, for example, the wireless-communication control unit 57 or the central control unit 61. When the central control unit 61 performs the computation, after the update of the neighbor table 64 ends, the wireless-communication control unit 57 notifies the central control unit 61 that the update ends. The central control unit 61 then performs the movement determination computation based on the information registered in the neighbor table 64. Details of the movement determination computation are explained later.

A value calculated by the movement determination computation is then compared to the threshold set at Step S12 described above. When the calculated value is smaller than the threshold (NO at Step S21), the process returns to Step S11. Meanwhile, when the calculated value is equal to or larger than the threshold (YES at Step S21), a relay is set to be OPEN (Step S22). That is, it is determined that theft has occurred when the calculated value is equal to or larger than the threshold, and the central control unit 61 controls the relay 62 to open an electric-power supply circuit, so that supply of electric power to a customer is stopped. Occurrence of theft is then reported to a higher-level management server 1 (Step S23). The report to the management server 1 is made by the wireless-communication control unit 57 transferring a movement notification (information indicating occurrence of theft) to the data-relay processing unit 53 and the data-relay processing unit 53 transmitting the movement notification to the data collecting device 2 based on the routing table 54. When the data collecting device 2 receives the movement notification from the electricity meter, the data collecting device 2 transfers the notification to the management server 1.

The movement determination computation performed at Step S20 described above is explained with reference to FIGS. 6 to 11. The respective electricity meters 5 are distinguished from each other by combining reference signs with IDs of the respective electricity meters. For example, an electricity meter 5A indicates the electricity meter 5 with its ID being "A".

An example of FIG. 6 is examined. That is, there is examined a case where, in an initial state, electricity meters 5B, 5C, and 5D are installed around the electricity meter 5A, their electric-field intensity levels are 5, 4, and 4, respectively, and after a certain period of time has elapsed and the neighbor table of the electricity meter 5A is updated, electricity meters 5D, 5E, and 5F are installed around the electricity meter 5A and their electric-field intensity levels are 2, 5, and 4, respectively. The neighbor table 64 shown in FIG. 6 is the neighbor table 64 of the electricity meter 5A.

In this case, with respect to the movement of the electricity meter 5A, a rate of a change in other peripheral electricity meters 5 before and after updating the neighbor table is computed by using the following equation (1) with the corresponding electricity meter 5A as a reference.

$$\text{"rate of change in electricity meter"} = (\text{"number of electricity meters changed after update"} \div \text{"number of electricity meters before update"}) \times 100 \quad \cdots (1)$$

where "number of electricity meters changed after update" = "number of electricity meters added + number of electricity meters removed" + "number of electricity meters whose electric-field intensity levels are changed"

In the example shown in FIG. 6, with respect to the change in another electricity meter 5 around the electricity meter 5A, the number of the electricity meters 5 added is 2 (the electricity meters 5E and 5F), the number of the electricity meters 5 removed is 2 (the electricity meters 5B and 5C), the number of the electricity meters whose electric-field intensity levels are changed is 1 (the electricity meter 5D) (see FIG. 7), and the number of the electricity meters 5 before updating the neighbor table is 3. When these numbers are applied to the equation (1) mentioned above, the following equation is provided.

$$\text{"rate of change in electricity meter"} = (5 \div 3) \times 100 = 167\%$$

This rate as a computation result is, as explained in Step S21 described above, compared to the threshold set in advance. When the rate is equal to or larger than the threshold, it is determined that the movement of the electricity meter 5A has occurred (theft of the electricity meter 5A has occurred) (for example, when the threshold is set to 60%, it is determined that the movement has occurred in the example of FIG. 6). Further, when it is determined that the movement has occurred, the relay is opened to report the determination to a higher-level device (corresponding to processing of Steps S22 and S23 explained above).

When the threshold of the movement determination computation is 60%, according to an example shown in FIG. 8, with respect to the change in another electricity meter 5 around the electricity meter 5A, the number of the electricity meters 5 added is 3 (electricity meters 5F, 5G, and 5H), the number of the electricity meters 5 removed is 4 (the electricity meters 5B, 5C, 5D, and 5E), the number of the electricity meters 5 whose electric-field intensity levels are changed is 0 (see FIG. 9), and the number of the electricity meters 5 before updating the neighbor table is 4. When these numbers are applied to the equation (1) mentioned above, the following equation is provided and it is determined that the movement has occurred.

$$\text{"rate of change in electricity meter"} = (7 \div 4) \times 100 = 175\%$$

As another example of the case where the threshold of the movement determination computation is 60%, a case shown in FIG. 10 is examined. According to an example shown in FIG. 10, the number of the electricity meters 5 added is 1 (the electricity meter 5F), the number of the electricity meters 5 removed is 1 (the electricity meter 5B), and no electricity meter 5 whose electric-field intensity level is changed is provided (see FIG. 11). The number of the electricity meters 5 before updating the neighbor table is 4. Accordingly, the following movement determination computation is provided and it is determined that no movement has occurred.

$$\text{"rate of change in electricity meter"} = (2 \div 4) \times 100 = 50\% < \text{"movement determination computation threshold"}: 60\%$$

The threshold of the movement determination can be arbitrarily set by an electric power company that installs the electricity meter 5. By changing the level of determining the movement of the electricity meter 5 depending on its installation environment or usage environment, a theft determination can be accurately performed. It can be also configured such that the electricity meter 5 that can directly communicate with the data collecting device 2 measures the electric-field intensity of a signal received from the data collecting device 2 and uses the electric-field intensity at the time of the movement determination computation.

As explained above, in the wireless mesh system according to the present embodiment, the electricity meter determines whether theft has occurred based on an amount of variation in the number of other electricity meters that can perform direct communication and the amount of variation in received power of a signal transmitted from each peripheral electricity meter. When it is detected that theft has occurred, the operation of supplying electric power to a customer is stopped. Consequently, even when theft is attempted, theft of electricity by a thief can be prevented.

Second embodiment.

An electricity meter according to a second embodiment is explained. Configurations of a communication network formed by an electricity meter, a wireless mesh system, a data collecting device, and an electricity meter are same as those in the first embodiment (see FIGS. 1 to 4).

A theft detection operation of the electricity meter 5 according to the present embodiment is explained with reference to FIG. 12. FIG. 12 is an example of a theft detection procedure of the electricity meter 5 according to the second embodiment. Processes common to the theft detection operation (FIG. 5) explained in the first embodiment are denoted by like step numbers as those in FIG. 5, and explanations thereof will be omitted.

According to the theft detection operation of the electricity meter 5 of the present embodiment, Step S31 is inserted between Steps S12 and S13 of the theft detection operation explained in the first embodiment and Step S32 is inserted between Steps S19 and S20.

A threshold of a change in the number of hops is set at Step S31. At Step S32, the amount of change in the number of hops according to update of a table at Step S19 is compared to the threshold set at Step S31. When the amount of change in the number of hops is equal to or larger than the threshold (YES at Step S32), Step S20 and processing subsequent to Step S20 are performed. That is, when the neighbor table is updated at Step S19 in the theft detection operation of the first embodiment, the transfer determination computation is always performed. Meanwhile, according to the theft detection operation of the present embodiment, when the amount of change in the number of hops is smaller than the threshold, the movement determination computation is not performed. This number of hops is the number of hops from the electricity meter 5 that performs the theft detection operation to the data collecting device 2 connected to the electricity meter 5. According to the present embodiment, because the movement determination computation is performed only when necessary, a processing load can be reduced.

A specific example of a case of performing the movement determination computation by considering the amount of change in the number of hops (a specific example of Steps S32 and S20) is explained with reference to FIGS. 13 to 15.

An example of FIG. 13 is examined. That is, there is examined a case where, in an initial state, the electricity meters 5B and 5C are installed around the electricity meter 5A, their electric-field intensity levels are 2 and 5, respectively, the electricity meter 5A whose number of hops is 5 is connected to a data collecting device 2AA (the data collecting device 2 with its ID being AA), and after a certain period of time has elapsed and the neighbor table of the electricity meter 5A is updated, the electricity meters 5B and 5C are installed around the electricity meter 5A, their electric-field intensity levels are 2 and 4, respectively, and the electricity meter 5A whose number of hops is 4 is connected to the data collecting device 2AA. The neighbor table 64 shown in FIG. 13 is the neighbor table 64 of the electricity meter 5A.

When the threshold of the movement determination computation is set to 60% and the threshold of a change in the number of hops is set to 3, according to the example shown in FIG. 13, because the amount of change in the number of hops is 1, which is smaller than the threshold, the movement determination computation is not performed. When it is determined that the amount of change in the number of hops is equal to or larger than the threshold and the movement determination computation is performed, the following movement determination computation is provided.

$$\text{"rate of change in electricity meter"} = (1 \div 2) \times 100 = 50\% <$$
$$\text{"movement determination computation threshold"}: 60\%$$

When the threshold of the movement determination computation is 60% and the threshold of the change in the number of hops is 3, according to an example shown in FIG. 14, with respect to a change in another electricity meter 5 around the electricity meter 5A, the number of the electricity meters 5 added is 0, the number of the electricity meters 5 removed is 0, and the number of the electricity meters 5 whose electric-field intensity levels are changed is 1. The amount of change in the number of hops is 5 and the number of the electricity meters 5 before updating the neighbor table is 2. Accordingly, the amount of change in the number of hops is equal to or larger than the threshold and the movement determination computation is performed. The movement determination computation is as follows and it is determined that no movement has occurred.

$$\text{"rate of change in electricity meter"} = (1 \div 2) \times 100 = 50\% <$$
$$\text{"movement determination computation threshold"}: 60\%$$

As another example of the case where the threshold of the movement determination computation is 60% and the threshold of the change in the number of hops is 3, an example shown in FIG. 15 is examined. According to the example shown in FIG. 15, the number of the electricity meters 5 added is 2 (the electricity meters 5E and 5F), the number of the electricity meters 5 removed is 2 (the electricity meters 5B and 5C), and no electricity meter 5 whose electric-field intensity level is changed is provided. The amount of change in the number of hops is 5 and the number of the electricity meters 5 before updating the neighbor table is 2. Accordingly, the following movement determination computation is provided and it is determined that a movement has occurred.

$$\text{"rate of change in electricity meter"} = (4 \div 2) \times 100 = 200\% <$$
$$\text{"movement determination computation threshold"}: 60\%$$

As explained above, the electricity meter according to the present embodiment performs the movement determination computation when the number of hops to the data collecting device is equal to or larger than the threshold. Accordingly, when it is less possible that the electricity meter is moved, the movement determination computation is not performed, so that the number of computations performed can be suppressed and the processing load can be reduced. Further, because the threshold of the movement determination computation and a threshold of determining a change in the number of hops can be arbitrarily set, a more accurate theft determination is possible as compared to the first embodiment.

Third embodiment.

An electricity meter according to a third embodiment is explained. Configurations of a communication network formed by an electricity meter, a wireless mesh system, a data collecting device, and an electricity meter are same as those in the first embodiment (see FIGS. 1 to 4).

A theft detection operation of the electricity meter 5 according to the present embodiment is explained with reference to FIG. 16. FIG. 16 is an example of a theft detection procedure of the electricity meter 5 according to the third embodiment. Processes common to the theft detection operation (FIG. 5 and FIG. 12) explained in the first and second embodiments are denoted by like step numbers as those in FIG. 5 and FIG. 12, and explanations thereof will be omitted.

According to the theft detection operation of the electricity meter 5 of the present embodiment, Step S41 is inserted between Steps S19 and S32 of the theft detection operation explained in the second embodiment.

At Step S41, it is confirmed whether an ID (a concentrator ID) of the data collecting device 2 connected to the electricity meter 5 is changed, that is, the connecting data collecting device 2 is changed. When the ID is changed (YES at Step S41), Step S32 is performed to compare the amount of change in the number of hops to the threshold. When the ID is not changed (NO at Step S41), Step S32 is not performed and then the movement determination computation at Step S20 is performed.

A specific example of a case of performing the movement determination computation by considering a change in the connecting data collecting device 2, a change in the concentrator ID, and the amount of change in the number of hops (a specific example of Steps S32 and S20) is explained with reference to FIG. 17.

An example of FIG. 17 is considered. That is, a case where in an initial state, the electricity meters 5B and 5C are installed around the electricity meter 5A and their electric-field intensity levels are 2 and 5, respectively, the electricity meter 5A whose number of hops is 5 is connected to the data collecting device 2AA, and after a certain period of time has elapsed and the neighbor table of the electricity meter 5A is updated, the electricity meters 5E and 5F are installed around the electricity meter 5A, their electric-field intensity levels are 4 and 2, respectively, and the electricity meter 5A whose number of hops is 10 is connected to the data collecting device 2BB is examined. The neighbor table 64 shown in FIG. 17 is the neighbor table 64 of the electricity meter 5A.

When the threshold of the movement determination computation is set to 60% and the threshold of a change in the number of hops is set to 3, according to the example shown FIG. 17, with respect to a change in other electricity meters 5 around the electricity meter 5A, the number of the electricity meters 5 added is 2 (the electricity meters 5E and 5F), the number of the electricity meters 5 removed is 2 (the electricity meters 5B and 5C), no electricity meter 5 whose electric-field intensity level is changed is provided, and the amount of change in the number of hops is 5. Accordingly, a determination is made as follows and it is determined that a movement has occurred.

"change in ID of connected data collecting device": YES (change from AA to BB)
"change in number of hops": 5> "threshold of change in number of hops": 3

"movement computation": $(4 \div 2) \times 100 = 200\%>$ "threshold of movement determination computation": 60%

As explained above, the electricity meter according to the present embodiment defines whether the movement determination computation is performed based on whether the connecting data collecting device has been changed and the amount of change in the number of hops to the data collecting device. Accordingly, similarly to the second embodiment, when it is less possible that the electricity meter 5 is moved, the movement determination computation is not performed, so that the number of computations performed can be suppressed and the processing load can be reduced. Furthermore, more accurate theft detection is possible as compared to the second embodiment.

While prevention of theft of electricity in a case of applying a prepayment system has been explained in the respective embodiments, as described above, when the electricity meter according to the present invention detects theft, an electric-power supply operation is stopped and thus the electricity meter cannot be used as the original electricity meter. With this configuration, the present invention can also contribute to theft prevention of an electricity meter in a system that does not apply a prepayment system.

Industrial Applicability

As described above, the present invention is useful for an electric-power supply system, and particularly suitable for an electric meter used in an electric-power supply system that applies a prepayment system.

Reference Signs List

| | |
|---|---|
| 1 | management server |
| 2 | data collecting device |
| 3 | wide area network |
| 4 | optical cable |
| 5 | electricity meter |
| 21 | data-collecting-device central control unit |
| 22 | wireless processing unit |
| 23, 60 | communication processing unit |
| 24 | optical input/output unit |
| 30, 50 | antenna |
| 31, 51 | wireless unit |
| 32, 52 | wireless I/F unit |
| 33 | wireless-network control unit |
| 34, 54 | routing table |
| 35, 55 | electric-field intensity measurement unit |
| 36, 56 | antenna switch |
| 37, 57 | wireless-communication control unit |
| 53 | data-relay processing unit |
| 58 | communication timer unit |
| 59 | communication storage unit |
| 61 | central control unit |
| 62 | Relay |
| 63 | metering unit |
| 64 | Neighbor table |
| 65 | control storage unit |

## Claims

**1.** An electricity meter that forms a wireless mesh network with one or more data collecting devices collecting electric energy data, the electricity meter comprising:

a wireless communication unit that transmits an amount of electricity consumed by a customer directly or via other adjacent electricity meters to a data collecting device selected as a data transmission destination;
a movement detection unit that determines existence of a movement of the electricity meter itself based on number of variations in adjacent electricity meters and existence of a variation in a reception level of a signal transmitted from each of the adjacent electricity meters; and
an electric-power supply control unit that stops an operation of a circuit of supplying electric power to a customer when it is determined that "movement exists" by the movement detection unit.

**2.** The electricity meter according to claim 1, wherein the movement detection unit monitors whether number of hops to the data collecting device selected as a data transmission destination has varied and determines whether existence of the movement needs to be determined based on a result of the monitoring.

**3.** The electricity meter according to claim 2, wherein the movement detection unit determines existence of the movement when an amount of variation in the number of hops is equal to or larger than a predetermined threshold.

**4.** The electricity meter according to claim 1, wherein the movement detection unit monitors whether number of hops to the data collecting device selected as a data transmission destination has varied and whether the data collecting device selected as a data transmission destination has been changed, and determines whether existence of the movement needs to be determined based on a result of the monitoring.

**5.** The electricity meter according to claim 4, wherein the movement detection unit determines existence of the movement when the data collecting device selected as a data transmission destination is not changed and when the data collecting device selected as a data transmission destination is changed and the amount of variation in the number of hops is equal to or larger than a predetermined threshold.

**6.** A theft detection method of an electricity meter in which an electricity meter forming a wireless mesh network with one or more data collecting devices collecting electric energy data detects theft of the electricity meter itself, the method comprising:

a variation monitoring step of calculating number of variations in adjacent electricity meters and determining existence of a variation in a reception level of a signal transmitted from each of the adjacent electricity meters based on a result of wireless communication with other electricity meters; and
a theft determining step of determining whether the electricity meter itself has been stolen based on number of variations in adjacent electricity meters and existence of a variation in a reception level of a signal transmitted from each of the adjacent electricity meters.

**7.** The theft detection method of an electricity meter according to claim 6, further comprising:

a number-of-hops monitoring step of monitoring whether number of hops to a data collecting device selected as a data transmission destination has varied; and
a necessity determining step of determining whether the theft determining step needs to be performed based on a result of monitoring the number of hops.

**8.** The theft detection method of an electricity meter according to claim 7, wherein when the amount of variation in the number of hops is equal to or larger than a predetermined threshold, it is determined that the theft determining step needs to be performed at the necessity determining step.

**9.** The theft detection method of an electricity meter according to claim 6, further comprising:

a monitoring step of monitoring whether number of hops to a data collecting device selected as a data transmission destination has varied and whether the data collecting device selected as a data transmission destination has been changed; and
a necessity determining step of determining whether the theft determination step needs to be performed based on a result of monitoring the number of hops and a result of monitoring whether the data collecting device selected as a data transmission destination has been changed.

**10.** The theft detection method of an electricity meter according to claim 9, wherein when the data collecting device selected as a data transmission destination is not changed and when the data collecting device selected as a data transmission destination has been changed and the amount of variation in the number of hops is equal to or larger than a predetermined threshold, it is determined that the theft determining step needs to be performed at the necessity determining step.

**11.** An electric-power supply system comprising a wireless mesh network formed by the electricity meter and the data collecting device collecting electric energy data according to any one of claims 1 to 5.

FIG.1

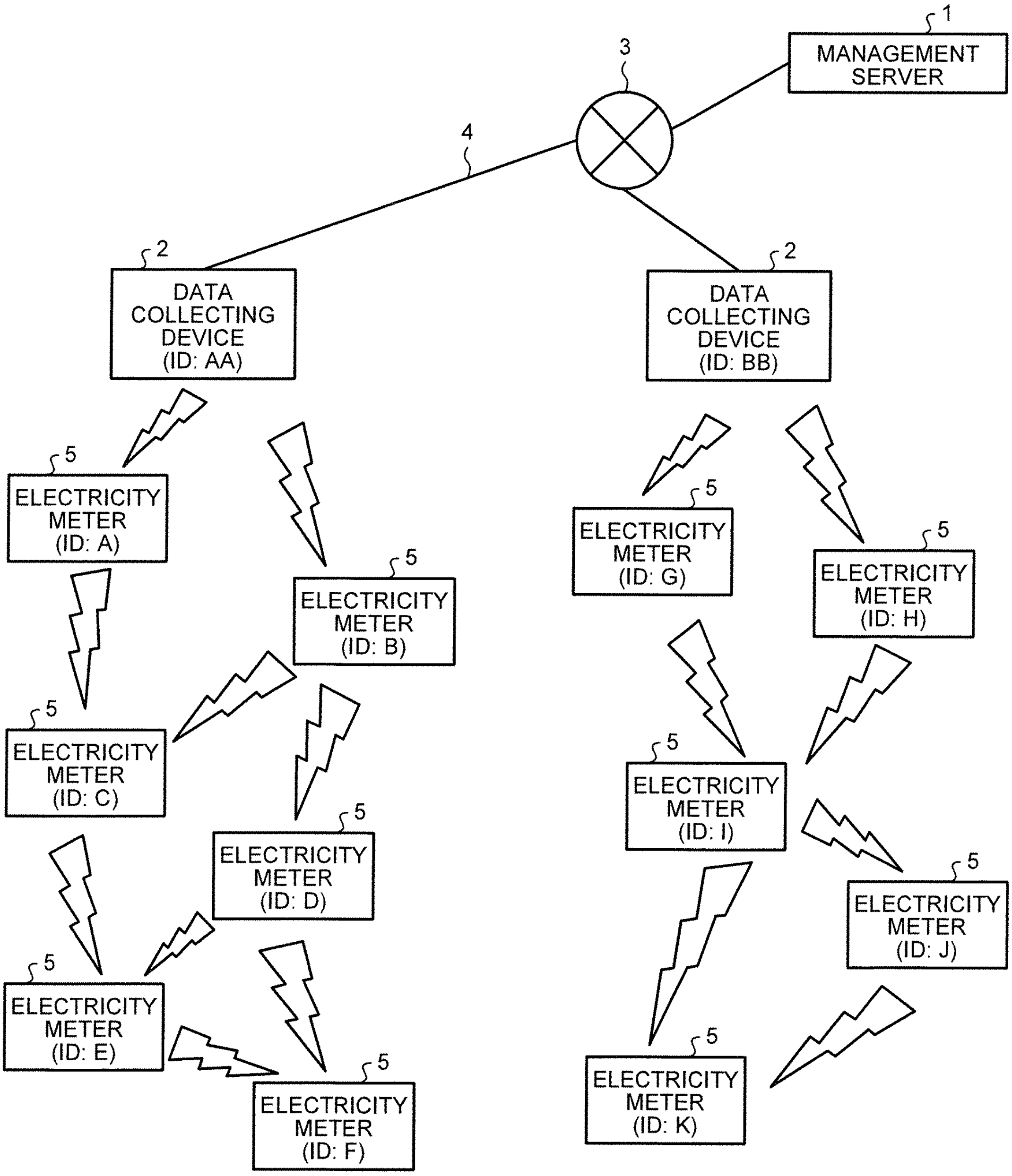
1
MANAGEMENT SERVER
3
4
2
DATA COLLECTING DEVICE (ID: AA)
2
DATA COLLECTING DEVICE (ID: BB)
5
ELECTRICITY METER (ID: A)
5
ELECTRICITY METER (ID: B)
5
ELECTRICITY METER (ID: C)
5
ELECTRICITY METER (ID: D)
5
ELECTRICITY METER (ID: E)
5
ELECTRICITY METER (ID: F)
5
ELECTRICITY METER (ID: G)
5
ELECTRICITY METER (ID: H)
5
ELECTRICITY METER (ID: I)
5
ELECTRICITY METER (ID: J)
5
ELECTRICITY METER (ID: K)

FIG.2

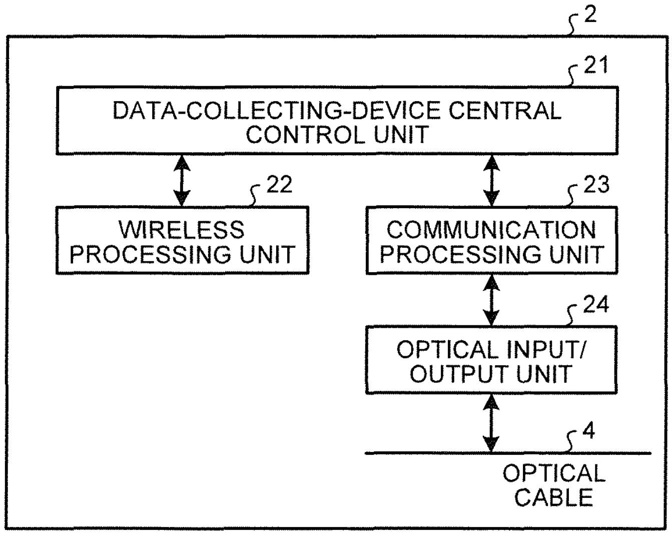
2
21
DATA-COLLECTING-DEVICE CENTRAL CONTROL UNIT
22
WIRELESS PROCESSING UNIT
23
COMMUNICATION PROCESSING UNIT
24
OPTICAL INPUT/ OUTPUT UNIT
4
OPTICAL CABLE

FIG.3

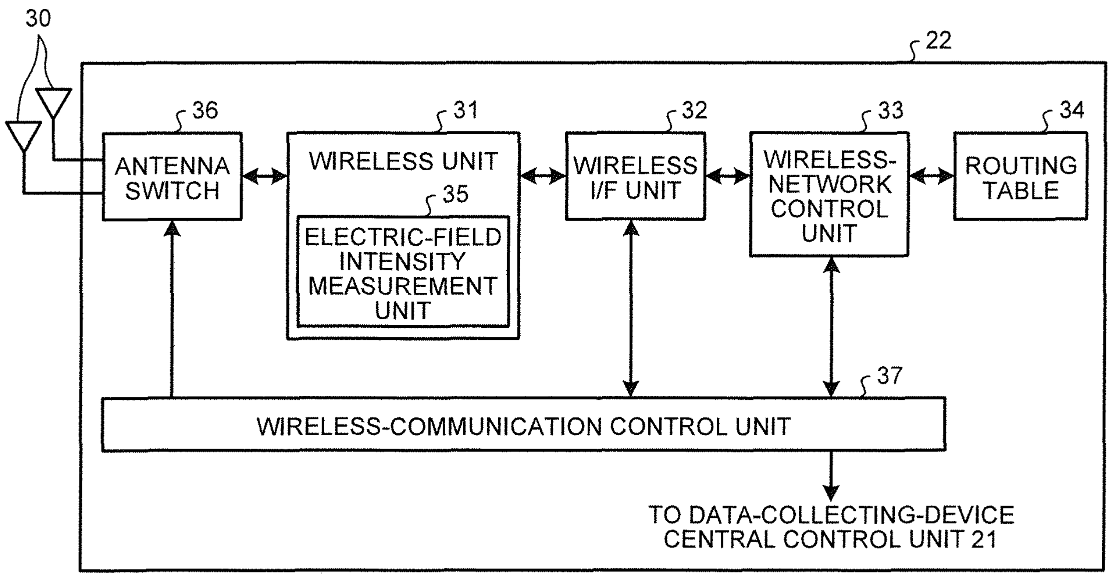
30
22
36
ANTENNA SWITCH
31
WIRELESS UNIT
35
ELECTRIC-FIELD INTENSITY MEASUREMENT UNIT
32
WIRELESS I/F UNIT
33
WIRELESS-NETWORK CONTROL UNIT
34
ROUTING TABLE
37
WIRELESS-COMMUNICATION CONTROL UNIT
TO DATA-COLLECTING-DEVICE CENTRAL CONTROL UNIT 21

FIG.4

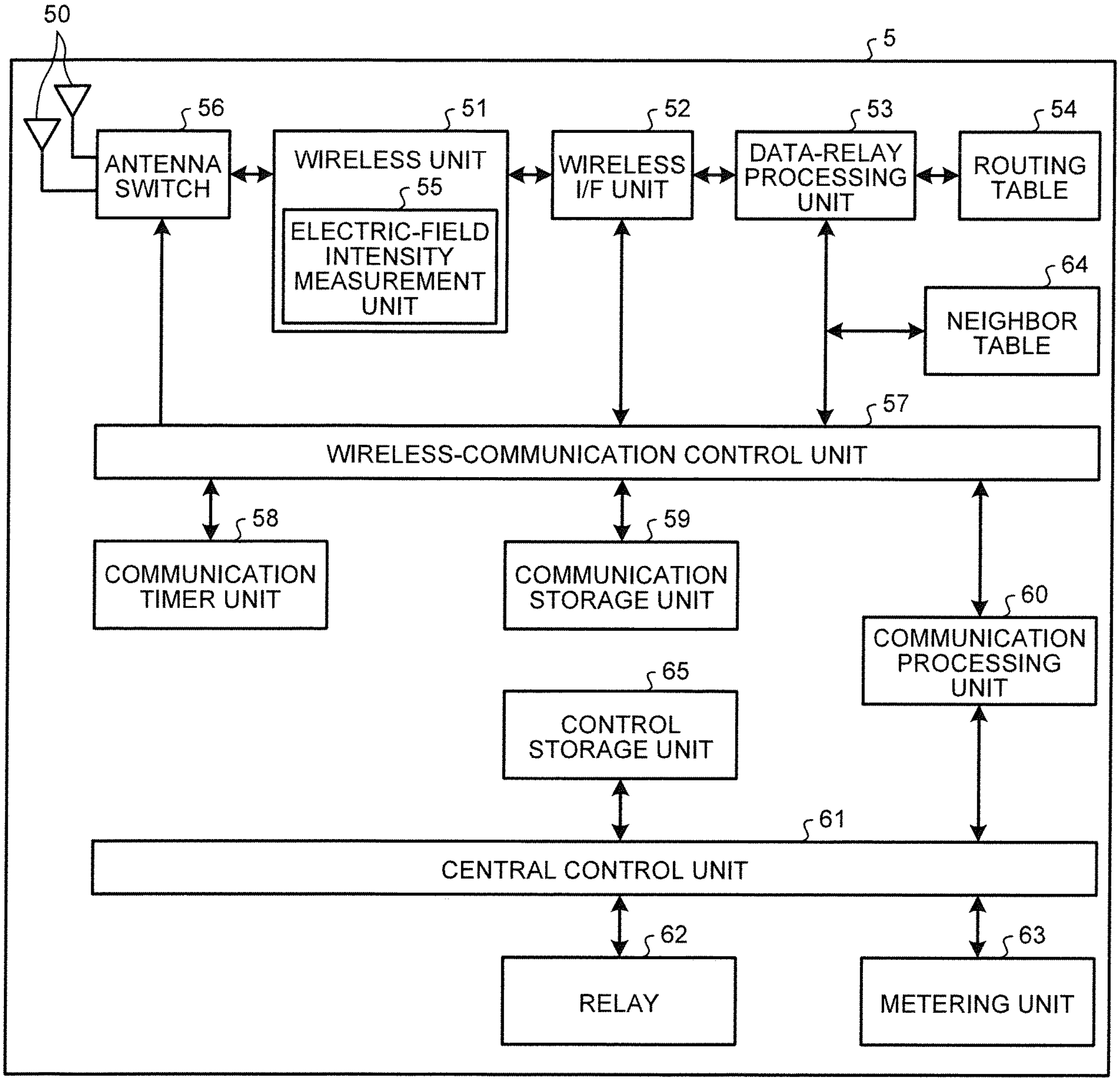
50
5
56
ANTENNA SWITCH
51
WIRELESS UNIT
55
ELECTRIC-FIELD INTENSITY MEASUREMENT UNIT
52
WIRELESS I/F UNIT
53
DATA-RELAY PROCESSING UNIT
54
ROUTING TABLE
64
NEIGHBOR TABLE
57
WIRELESS-COMMUNICATION CONTROL UNIT
58
COMMUNICATION TIMER UNIT
59
COMMUNICATION STORAGE UNIT
60
COMMUNICATION PROCESSING UNIT
65
CONTROL STORAGE UNIT
61
CENTRAL CONTROL UNIT
62
RELAY
63
METERING UNIT

FIG.5

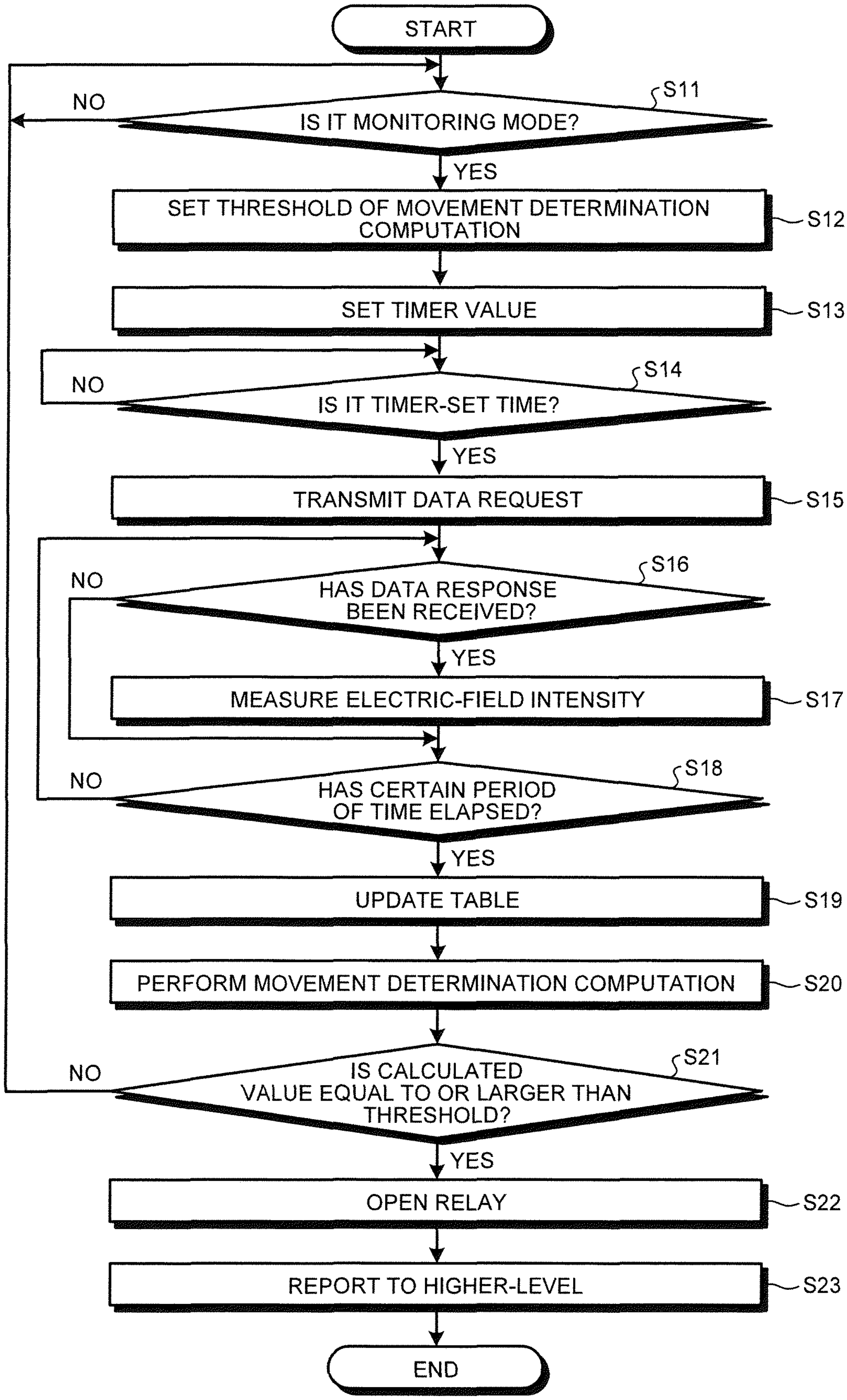
START
S11
NO
IS IT MONITORING MODE?
YES
SET THRESHOLD OF MOVEMENT DETERMINATION COMPUTATION
S12
SET TIMER VALUE
S13
S14
NO
IS IT TIMER-SET TIME?
YES
TRANSMIT DATA REQUEST
S15
S16
NO
HAS DATA RESPONSE BEEN RECEIVED?
YES
MEASURE ELECTRIC-FIELD INTENSITY
S17
S18
NO
HAS CERTAIN PERIOD OF TIME ELAPSED?
YES
UPDATE TABLE
S19
PERFORM MOVEMENT DETERMINATION COMPUTATION
S20
S21
NO
IS CALCULATED VALUE EQUAL TO OR LARGER THAN THRESHOLD?
YES
OPEN RELAY
S22
REPORT TO HIGHER-LEVEL
S23
END

FIG.6

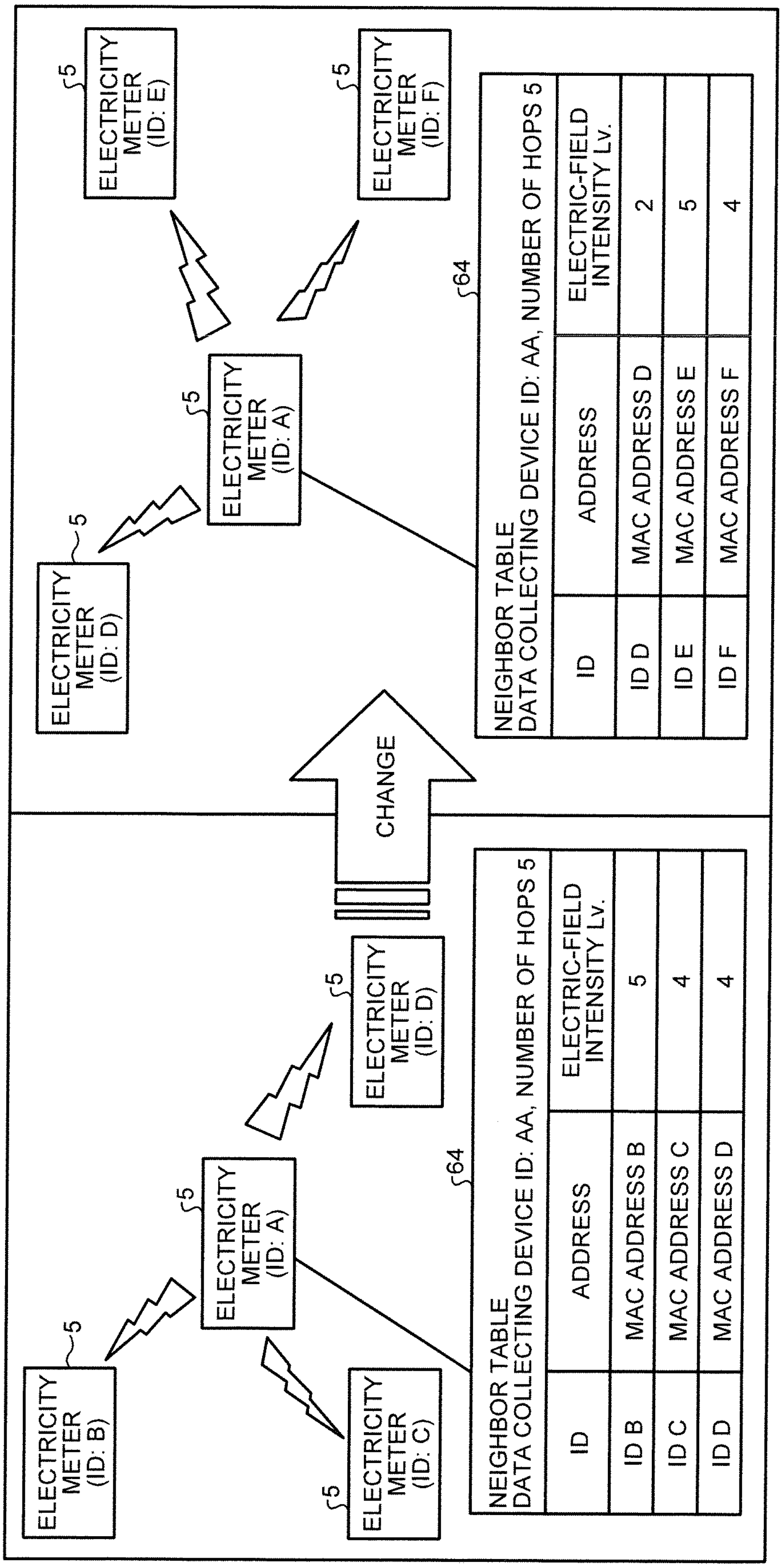
ELECTRICITY METER (ID: B)
ELECTRICITY METER (ID: A)
ELECTRICITY METER (ID: C)
ELECTRICITY METER (ID: D)
5
64
NEIGHBOR TABLE
DATA COLLECTING DEVICE ID: AA, NUMBER OF HOPS 5
ID | ADDRESS | ELECTRIC-FIELD INTENSITY Lv.
ID B | MAC ADDRESS B | 5
ID C | MAC ADDRESS C | 4
ID D | MAC ADDRESS D | 4
CHANGE
ELECTRICITY METER (ID: D)
ELECTRICITY METER (ID: A)
ELECTRICITY METER (ID: E)
ELECTRICITY METER (ID: F)
NEIGHBOR TABLE
DATA COLLECTING DEVICE ID: AA, NUMBER OF HOPS 5
ID | ADDRESS | ELECTRIC-FIELD INTENSITY Lv.
ID D | MAC ADDRESS D | 2
ID E | MAC ADDRESS E | 5
ID F | MAC ADDRESS F | 4

# FIG.7

| BEFORE UPDATE | | | AFTER UPDATE | | | CHANGE | |
|---|---|---|---|---|---|---|---|
| ID | ADDRESS | ELECTRIC-FIELD INTENSITY Lv. | ID | ADDRESS | ELECTRIC-FIELD INTENSITY Lv. | ADDED | E, F |
| ID B | MAC ADDRESS B | 5 | ID D | MAC ADDRESS D | 2 | REMOVED | B, C |
| ID C | MAC ADDRESS C | 4 | ID E | MAC ADDRESS E | 5 | ELECTRIC-FIELD INTENSITY Lv. | D |
| ID D | MAC ADDRESS D | 4 | ID F | MAC ADDRESS F | 4 | | |

FIG.8

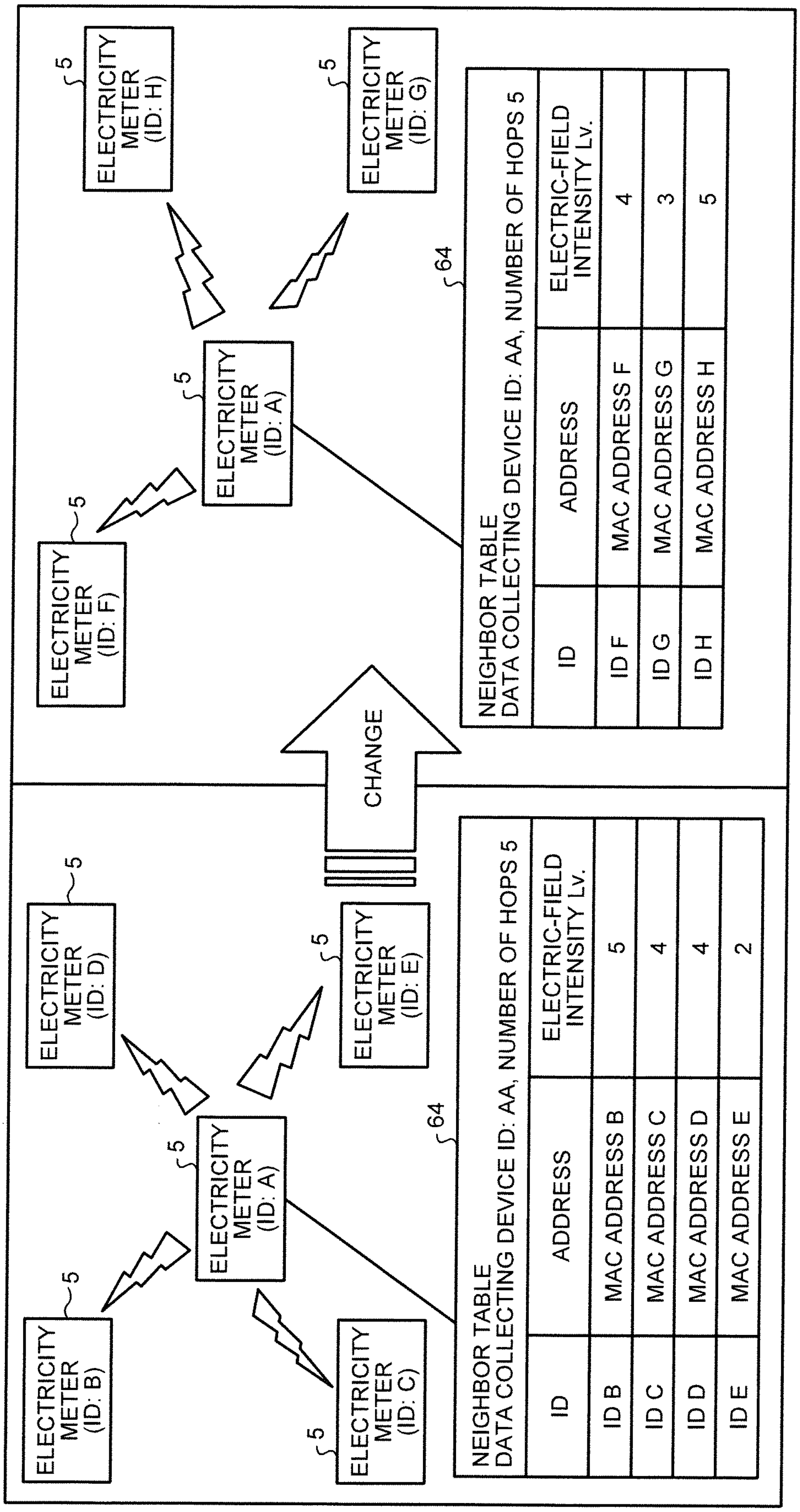
ELECTRICITY METER (ID: A)
ELECTRICITY METER (ID: B)
ELECTRICITY METER (ID: C)
ELECTRICITY METER (ID: D)
ELECTRICITY METER (ID: E)
5
64
NEIGHBOR TABLE
DATA COLLECTING DEVICE ID: AA, NUMBER OF HOPS 5
ID | ADDRESS | ELECTRIC-FIELD INTENSITY Lv.
ID B | MAC ADDRESS B | 5
ID C | MAC ADDRESS C | 4
ID D | MAC ADDRESS D | 4
ID E | MAC ADDRESS E | 2
CHANGE
ELECTRICITY METER (ID: A)
ELECTRICITY METER (ID: F)
ELECTRICITY METER (ID: G)
ELECTRICITY METER (ID: H)
NEIGHBOR TABLE
DATA COLLECTING DEVICE ID: AA, NUMBER OF HOPS 5
ID | ADDRESS | ELECTRIC-FIELD INTENSITY Lv.
ID F | MAC ADDRESS F | 4
ID G | MAC ADDRESS G | 3
ID H | MAC ADDRESS H | 5

# FIG.9

| BEFORE UPDATE | | | AFTER UPDATE | | | CHANGE | |
|---|---|---|---|---|---|---|---|
| ID | ADDRESS | ELECTRIC-FIELD INTENSITY Lv. | ID | ADDRESS | ELECTRIC-FIELD INTENSITY Lv. | ADDED | F, G, H |
| ID B | MAC ADDRESS B | 5 | ID F | MAC ADDRESS F | 4 | REMOVED | B, C, D, E |
| ID C | MAC ADDRESS C | 4 | ID G | MAC ADDRESS G | 3 | ELECTRIC-FIELD INTENSITY Lv. | NONE |
| ID D | MAC ADDRESS D | 4 | ID H | MAC ADDRESS H | 5 | | |
| ID E | MAC ADDRESS E | 2 | | | | | |

FIG.10

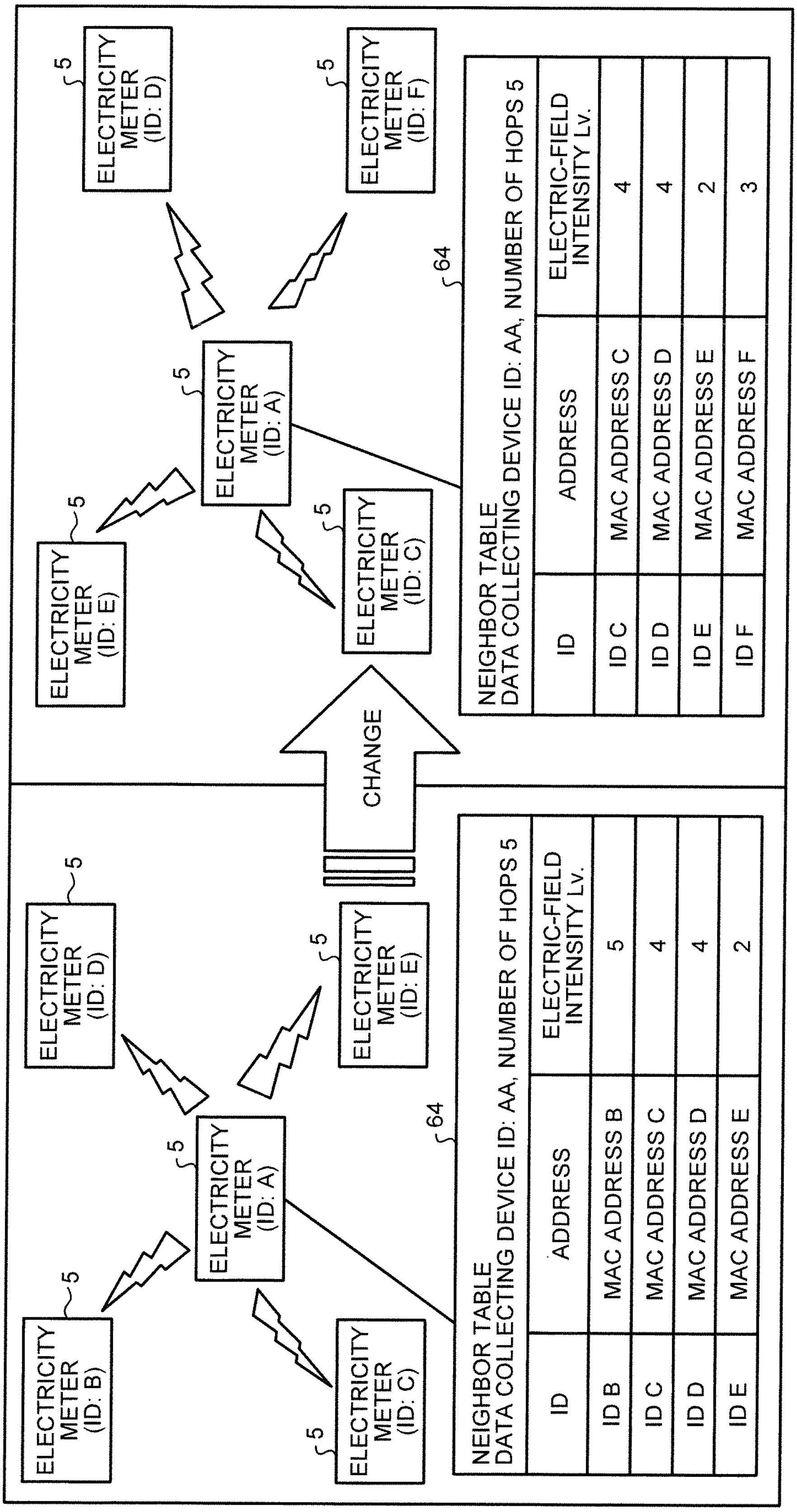

ELECTRICITY METER (ID: B)
ELECTRICITY METER (ID: C)
ELECTRICITY METER (ID: A)
ELECTRICITY METER (ID: D)
ELECTRICITY METER (ID: E)
5
64
NEIGHBOR TABLE
DATA COLLECTING DEVICE ID: AA, NUMBER OF HOPS 5
ID | ADDRESS | ELECTRIC-FIELD INTENSITY Lv.
ID B | MAC ADDRESS B | 5
ID C | MAC ADDRESS C | 4
ID D | MAC ADDRESS D | 4
ID E | MAC ADDRESS E | 2
CHANGE
ELECTRICITY METER (ID: E)
ELECTRICITY METER (ID: C)
ELECTRICITY METER (ID: A)
ELECTRICITY METER (ID: D)
ELECTRICITY METER (ID: F)
NEIGHBOR TABLE
DATA COLLECTING DEVICE ID: AA, NUMBER OF HOPS 5
ID | ADDRESS | ELECTRIC-FIELD INTENSITY Lv.
ID C | MAC ADDRESS C | 4
ID D | MAC ADDRESS D | 4
ID E | MAC ADDRESS E | 2
ID F | MAC ADDRESS F | 3

FIG.11

| BEFORE UPDATE | | | AFTER UPDATE | | | CHANGE | |
|---|---|---|---|---|---|---|---|
| ID | ADDRESS | ELECTRIC-FIELD INTENSITY Lv. | ID | ADDRESS | ELECTRIC-FIELD INTENSITY Lv. | ADDED | F |
| ID B | MAC ADDRESS B | 5 | ID C | MAC ADDRESS C | 4 | REMOVED | B |
| ID C | MAC ADDRESS C | 4 | ID D | MAC ADDRESS D | 4 | ELECTRIC-FIELD INTENSITY Lv. | NONE |
| ID D | MAC ADDRESS D | 4 | ID E | MAC ADDRESS E | 2 | | |
| ID E | MAC ADDRESS E | 2 | ID F | MAC ADDRESS F | 3 | | |

FIG.12

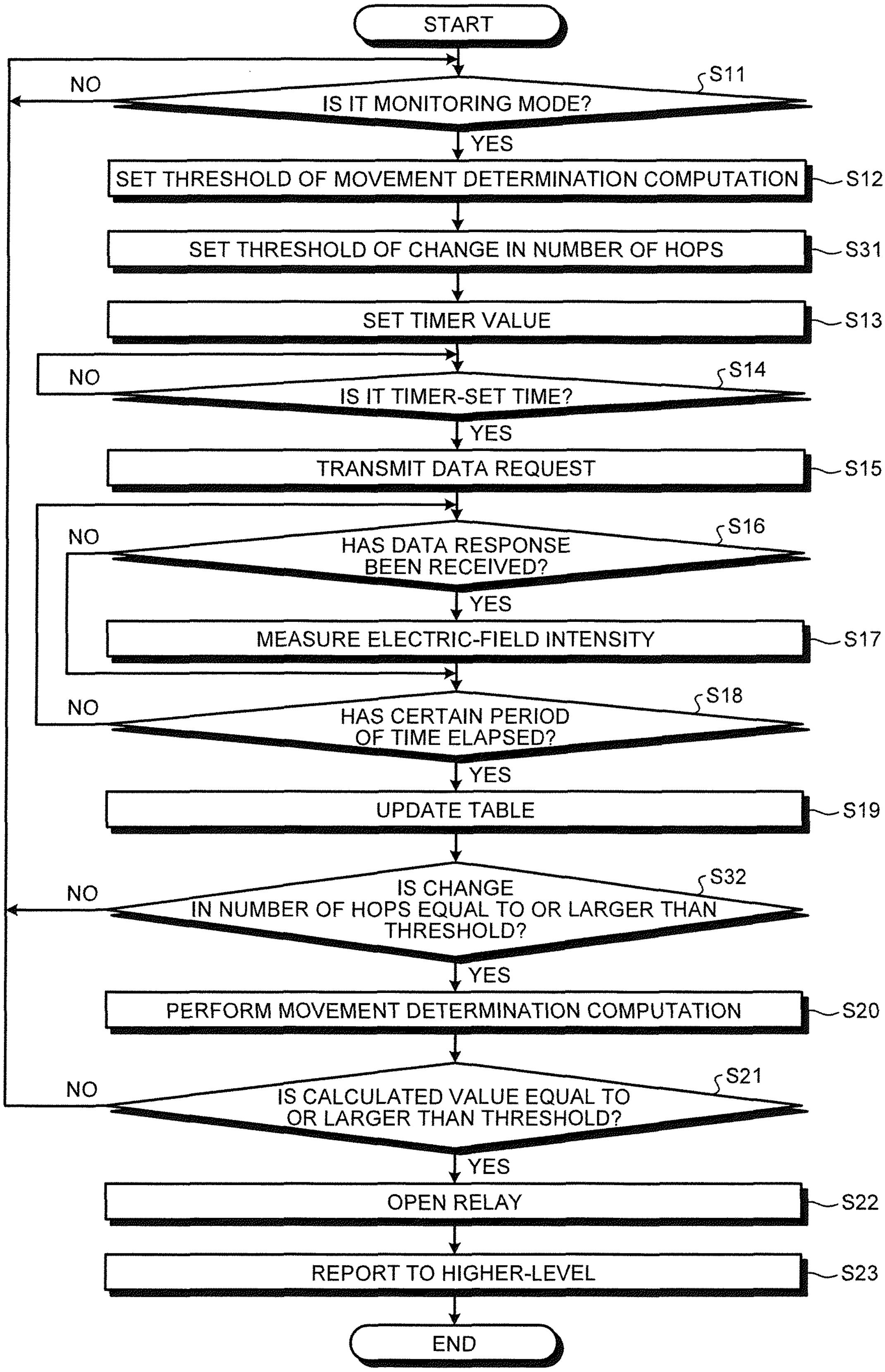
START
S11
IS IT MONITORING MODE?
NO
YES
SET THRESHOLD OF MOVEMENT DETERMINATION COMPUTATION
S12
SET THRESHOLD OF CHANGE IN NUMBER OF HOPS
S31
SET TIMER VALUE
S13
S14
IS IT TIMER-SET TIME?
NO
YES
TRANSMIT DATA REQUEST
S15
S16
HAS DATA RESPONSE BEEN RECEIVED?
NO
YES
MEASURE ELECTRIC-FIELD INTENSITY
S17
S18
HAS CERTAIN PERIOD OF TIME ELAPSED?
NO
YES
UPDATE TABLE
S19
S32
IS CHANGE IN NUMBER OF HOPS EQUAL TO OR LARGER THAN THRESHOLD?
NO
YES
PERFORM MOVEMENT DETERMINATION COMPUTATION
S20
S21
IS CALCULATED VALUE EQUAL TO OR LARGER THAN THRESHOLD?
NO
YES
OPEN RELAY
S22
REPORT TO HIGHER-LEVEL
S23
END

FIG.13

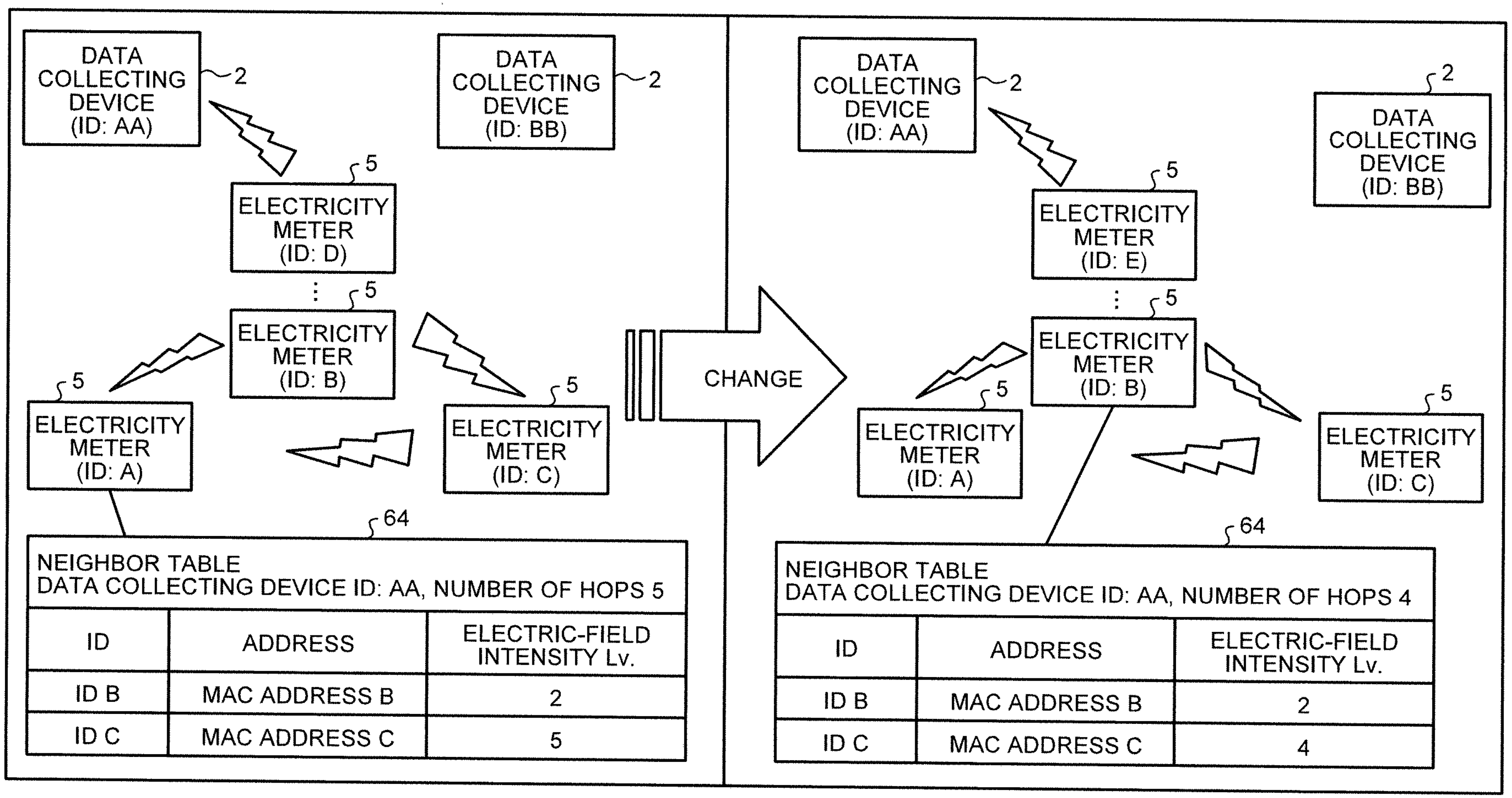
DATA COLLECTING DEVICE (ID: AA)
2
DATA COLLECTING DEVICE (ID: BB)
5
ELECTRICITY METER (ID: D)
ELECTRICITY METER (ID: B)
ELECTRICITY METER (ID: A)
ELECTRICITY METER (ID: C)
64
NEIGHBOR TABLE
DATA COLLECTING DEVICE ID: AA, NUMBER OF HOPS 5
ID | ADDRESS | ELECTRIC-FIELD INTENSITY Lv.
ID B | MAC ADDRESS B | 2
ID C | MAC ADDRESS C | 5
CHANGE
DATA COLLECTING DEVICE (ID: AA)
DATA COLLECTING DEVICE (ID: BB)
ELECTRICITY METER (ID: E)
ELECTRICITY METER (ID: B)
ELECTRICITY METER (ID: A)
ELECTRICITY METER (ID: C)
NEIGHBOR TABLE
DATA COLLECTING DEVICE ID: AA, NUMBER OF HOPS 4
ID | ADDRESS | ELECTRIC-FIELD INTENSITY Lv.
ID B | MAC ADDRESS B | 2
ID C | MAC ADDRESS C | 4

FIG.14

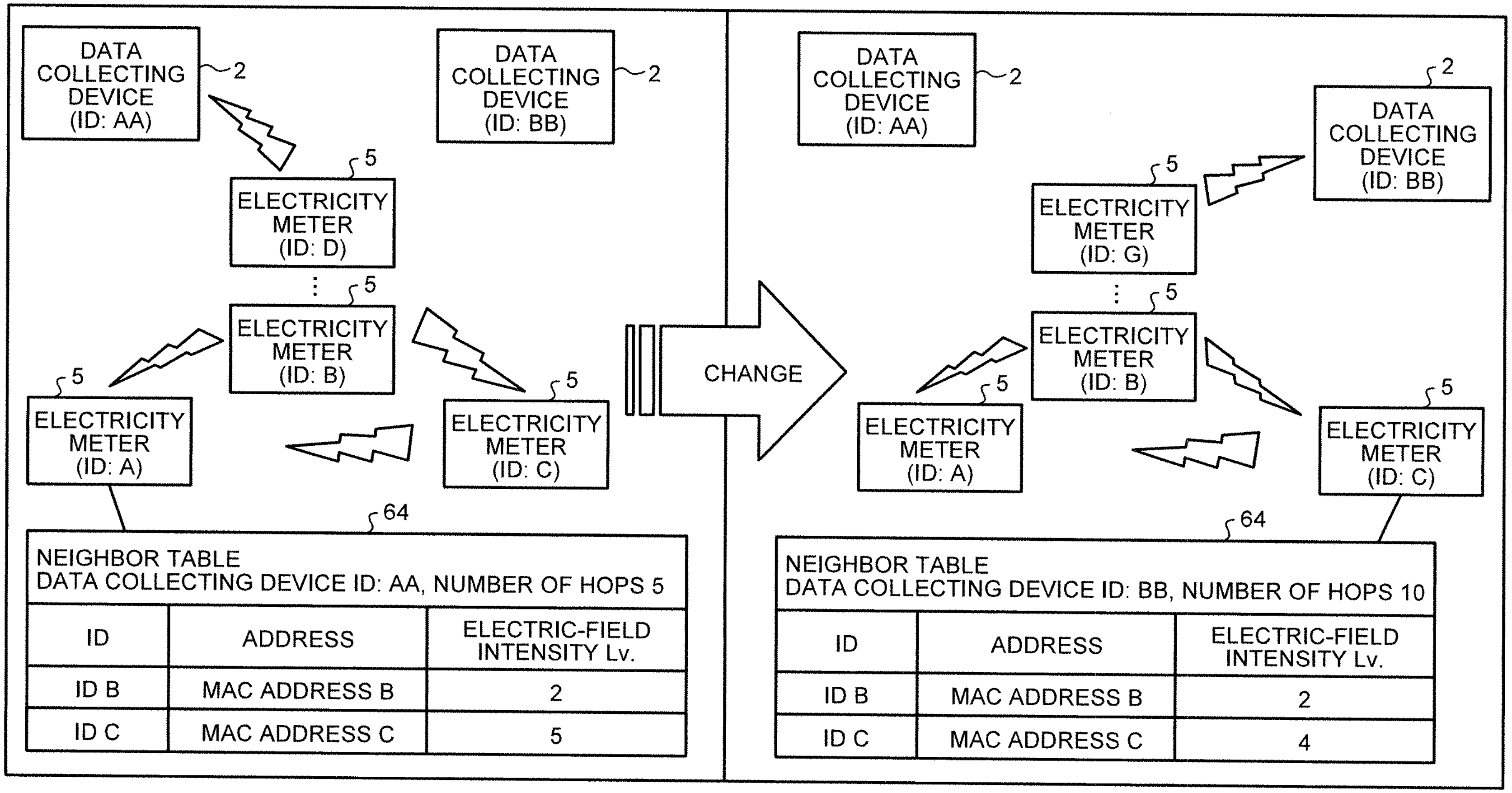
DATA COLLECTING DEVICE (ID: AA)
2
DATA COLLECTING DEVICE (ID: BB)
2
ELECTRICITY METER (ID: D)
5
ELECTRICITY METER (ID: B)
5
ELECTRICITY METER (ID: A)
5
ELECTRICITY METER (ID: C)
5
64
NEIGHBOR TABLE
DATA COLLECTING DEVICE ID: AA, NUMBER OF HOPS 5
ID
ADDRESS
ELECTRIC-FIELD INTENSITY Lv.
ID B
MAC ADDRESS B
2
ID C
MAC ADDRESS C
5
CHANGE
DATA COLLECTING DEVICE (ID: AA)
2
DATA COLLECTING DEVICE (ID: BB)
2
ELECTRICITY METER (ID: G)
5
ELECTRICITY METER (ID: B)
5
ELECTRICITY METER (ID: A)
5
ELECTRICITY METER (ID: C)
5
64
NEIGHBOR TABLE
DATA COLLECTING DEVICE ID: BB, NUMBER OF HOPS 10
ID
ADDRESS
ELECTRIC-FIELD INTENSITY Lv.
ID B
MAC ADDRESS B
2
ID C
MAC ADDRESS C
4

FIG.15

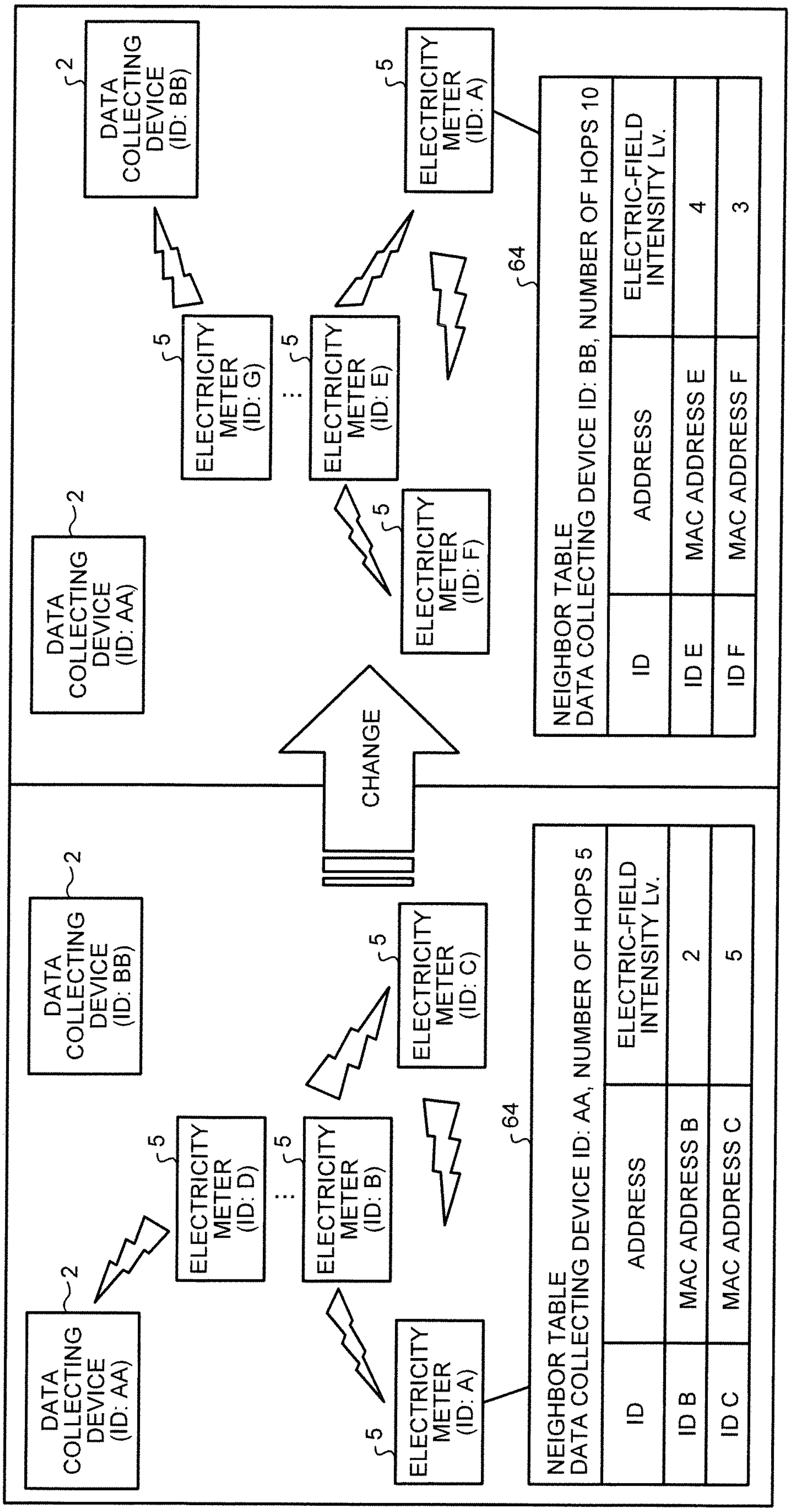
DATA COLLECTING DEVICE (ID: AA)
2
DATA COLLECTING DEVICE (ID: BB)
2
ELECTRICITY METER (ID: D)
5
ELECTRICITY METER (ID: B)
5
ELECTRICITY METER (ID: A)
5
ELECTRICITY METER (ID: C)
5
64
NEIGHBOR TABLE
DATA COLLECTING DEVICE ID: AA, NUMBER OF HOPS 5
ID | ADDRESS | ELECTRIC-FIELD INTENSITY Lv.
ID B | MAC ADDRESS B | 2
ID C | MAC ADDRESS C | 5
CHANGE
DATA COLLECTING DEVICE (ID: AA)
2
DATA COLLECTING DEVICE (ID: BB)
2
ELECTRICITY METER (ID: G)
5
ELECTRICITY METER (ID: E)
5
ELECTRICITY METER (ID: F)
5
ELECTRICITY METER (ID: A)
5
64
NEIGHBOR TABLE
DATA COLLECTING DEVICE ID: BB, NUMBER OF HOPS 10
ID | ADDRESS | ELECTRIC-FIELD INTENSITY Lv.
ID E | MAC ADDRESS E | 4
ID F | MAC ADDRESS F | 3

FIG.16

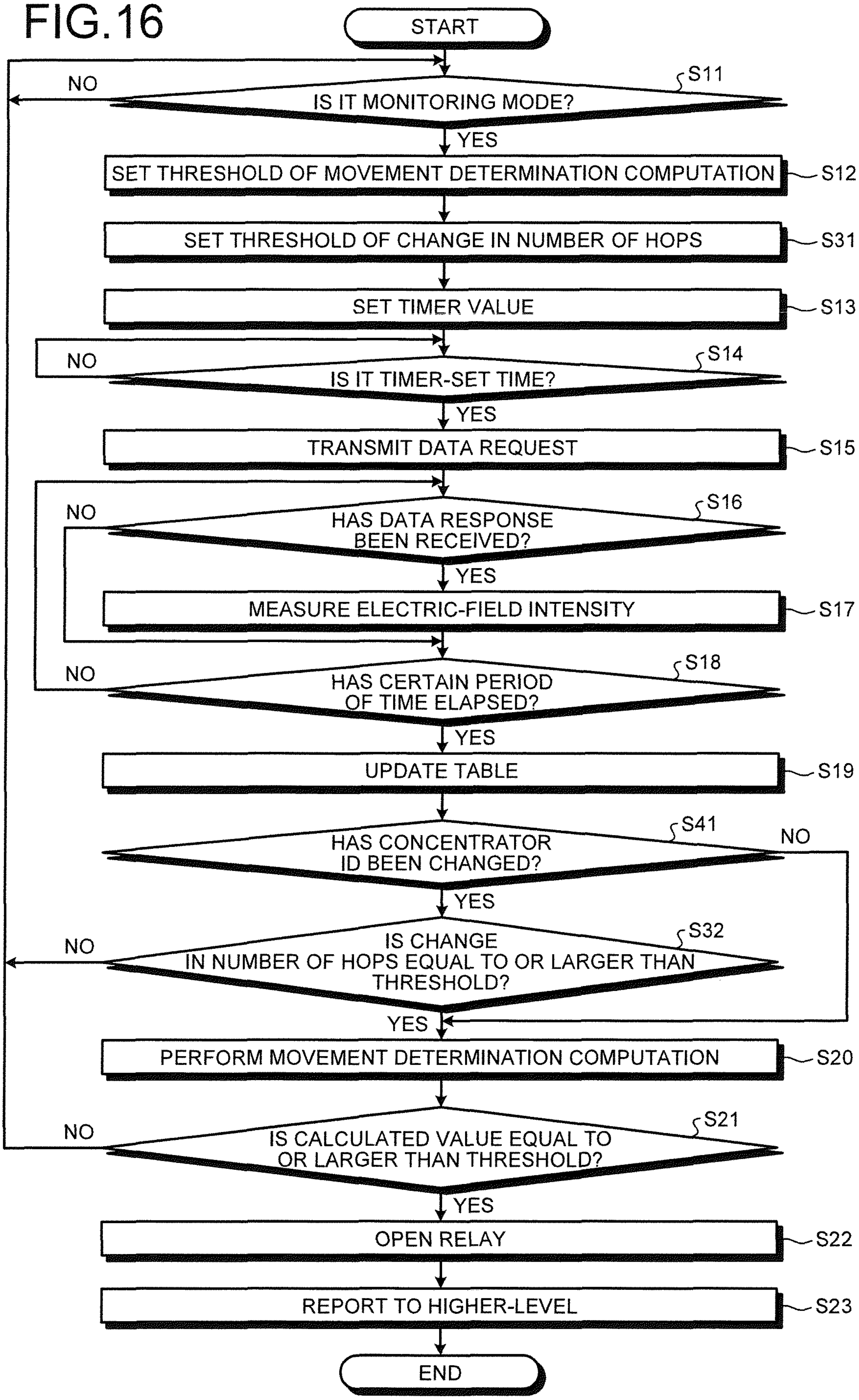
START
IS IT MONITORING MODE?
S11
NO
YES
SET THRESHOLD OF MOVEMENT DETERMINATION COMPUTATION
S12
SET THRESHOLD OF CHANGE IN NUMBER OF HOPS
S31
SET TIMER VALUE
S13
IS IT TIMER-SET TIME?
S14
NO
YES
TRANSMIT DATA REQUEST
S15
HAS DATA RESPONSE BEEN RECEIVED?
S16
NO
YES
MEASURE ELECTRIC-FIELD INTENSITY
S17
HAS CERTAIN PERIOD OF TIME ELAPSED?
S18
NO
YES
UPDATE TABLE
S19
HAS CONCENTRATOR ID BEEN CHANGED?
S41
NO
YES
IS CHANGE IN NUMBER OF HOPS EQUAL TO OR LARGER THAN THRESHOLD?
S32
NO
YES
PERFORM MOVEMENT DETERMINATION COMPUTATION
S20
IS CALCULATED VALUE EQUAL TO OR LARGER THAN THRESHOLD?
S21
NO
YES
OPEN RELAY
S22
REPORT TO HIGHER-LEVEL
S23
END

FIG.17

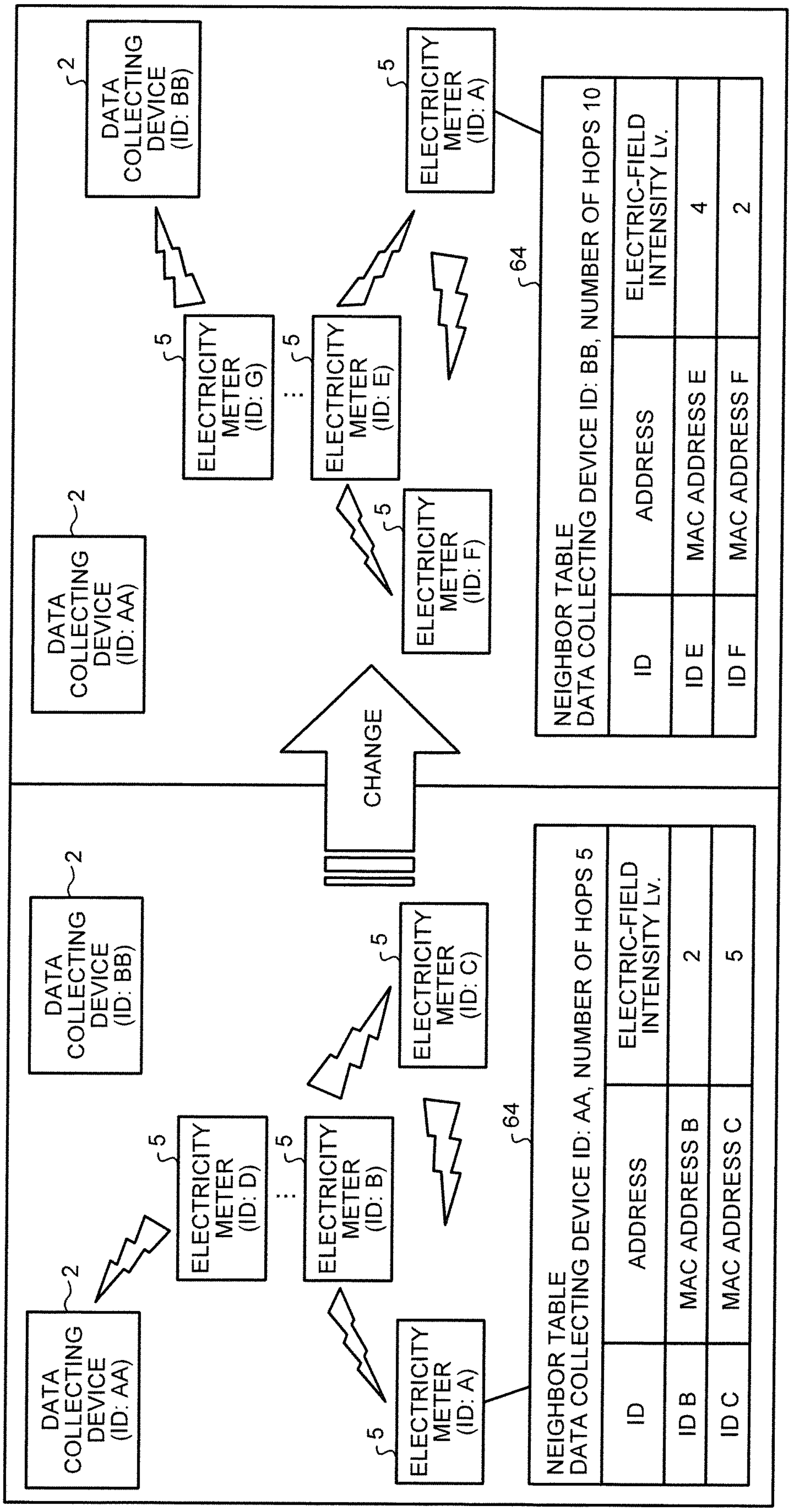
DATA COLLECTING DEVICE (ID: AA)
2
DATA COLLECTING DEVICE (ID: BB)
2
ELECTRICITY METER (ID: D)
5
ELECTRICITY METER (ID: B)
5
ELECTRICITY METER (ID: A)
5
ELECTRICITY METER (ID: C)
5
64
NEIGHBOR TABLE
DATA COLLECTING DEVICE ID: AA, NUMBER OF HOPS 5
ID | ADDRESS | ELECTRIC-FIELD INTENSITY Lv.
ID B | MAC ADDRESS B | 2
ID C | MAC ADDRESS C | 5
CHANGE
DATA COLLECTING DEVICE (ID: AA)
2
DATA COLLECTING DEVICE (ID: BB)
2
ELECTRICITY METER (ID: G)
5
ELECTRICITY METER (ID: E)
5
ELECTRICITY METER (ID: F)
5
ELECTRICITY METER (ID: A)
5
64
NEIGHBOR TABLE
DATA COLLECTING DEVICE ID: BB, NUMBER OF HOPS 10
ID | ADDRESS | ELECTRIC-FIELD INTENSITY Lv.
ID E | MAC ADDRESS E | 4
ID F | MAC ADDRESS F | 2

## INTERNATIONAL SEARCH REPORT

International application No.
PCT/JP2012/053022

A. CLASSIFICATION OF SUBJECT MATTER
*G01R22/00*(2006.01)i

According to International Patent Classification (IPC) or to both national classification and IPC

B. FIELDS SEARCHED

Minimum documentation searched (classification system followed by classification symbols)
G01R22/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2001-28093 A (Shikoku Electric Power Co., Inc.), 30 January 2001 (30.01.2001), paragraphs [0119] to [0126] (Family: none) | 1-11 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 April, 2012 (25.04.12) | 15 May, 2012 (15.05.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004340767 A